# EUROPEAN PATENT SPECIFICATION

(11) **EP 3 909 073 B1**
(45) Date of publication and mention of the grant of the patent: **06.03.2024**
(21) Application number: 21701160.0
(22) Date of filing: 27.01.2021
(51) Int. Cl.: H01L 23/48, H01L 23/34, H01L 23/473, H01L 23/62, H01L 25/07, H01L 23/31

(54) **POWER SEMICONDUCTOR MODULE WITH ACCESSIBLE METAL CLIPS**
LEISTUNGSHALBLEITERMODUL MIT ZUGÄNGLICHEN METALLKLAMMERN
MODULE D'ALIMENTATION À SEMI-CONDUCTEUR COMPORTANT DES CLIPS MÉTALLIQUES ACCESSIBLES

(30) Priority: 30.01.2020 EP 20154509
(43) Date of publication of application: 17.11.2021
(73) Proprietor: Hitachi Energy Ltd, 8050 Zürich (CH)
(72) Inventor: SCHUDERER, Juergen, 8047 Zürich (CH); PAVLICEK, Niko, 8041 Zürich (CH); LIU, Chunlei, 5452 Oberrohrdorf (CH); SCHROEDER, Arne, 3012 Bern (CH); SCHLOTTIG, Gerd, 8142 Uitikon Waldegg (CH)
(74) Representative: Epping - Hermann - Fischer
(86) International application number: PCT/EP2021/051868
(87) International publication number: WO 2021/151949

(56) References cited:
- JP-A- 2006 121 861
- JP-A- 2007 049 810
- JP-A- 2014 123 618
- US-A1- 2014 232 015

## Description

### FIELD OF THE INVENTION

The invention relates to the field of power electronics. In particular, the invention relates to a power semiconductor module.

### BACKGROUND OF THE INVENTION

Condition and health monitoring are effective means of improving the availability and lifetime of power electronic components, converters and systems. The active power semiconductor components usually are the main reasons for converter failures. Therefore, a precise determination of physical conditions of power semiconductor chips packaged into a module may be beneficial for predicting failures in advance.

Document US 2007/0132112 A1 shows a semiconductor module with a mold encapsulation, which has a groove to apply pressure on a leadframe below a chip during molding. The leadframe is pushed down by a vertical mold flow.

Document EP 2 447 991 A2 shows an electronic member, which comprises a chip on a substrate, which is connected on a top side via spring elements with a contact element. The contact element, the substrate and the chip are partially enclosed in a mold material, wherein a recess above the chip comprising the spring elements is left out.

Document US 2015/0214133 A1 shows an electronic device with a chip on a substrate, which on a top side is connected via a contact element with another part of the substrate. The substrate, chip and contact element are partially embedded in an encasing, wherein an area above the contact element is left free.

Document JP 2009-194327 A shows a semiconductor device with chips on a substrate, which are interconnected with a clip. The substrate, chips, and clip are enclosed in an encasing, wherein an area of the encasing above the clip has a recess.

Document JP 2014-123618 A shows a semiconductor module that comprises: circuit patterns provided on one main surface of a substrate; semiconductor elements joined onto the circuit patterns; and metal plates which join the circuit patterns with the semiconductor elements and/or join the semiconductor element with another semiconductor element. The substrate, the circuit patterns, the semiconductor elements, and the metal plates are sealed by a resin. Holes are formed in the resin. Parts of the circuit patterns, the semiconductor elements, or the metal plates are exposed from the holes in a plane view.

Document JP 2006-121861 A shows a power converter which includes a power circuit module formed by sealing a power circuit substrate having a power semiconductor with an insulation resin in such a state that a lead terminal is pulled to the outside, and the control circuit module which is made by sealing a control circuit substrate for drivingly controlling the power semiconductor with an insulation resin in such a state that a connection portion like a through hole is exposed to the outside. With this set-up, the lead terminal of the power circuit module is formed, mechanically being integrated and electrically being connected in such a state as to be connected with the connection portion of the control circuit module.

Document US 2014/0232015 A1 shows a semiconductor module that includes a first semiconductor package having a first semiconductor die, which is disposed in a first encapsulant. An opening is disposed in the first encapsulant. A second semiconductor package including a second semiconductor die is disposed in a second encapsulant. The second semiconductor package is disposed at least partially within the opening in the first encapsulant.

Document JP 2007-049810 A refers to an IGBT (power semiconductor element) which is arranged on the cooling surface of a cooler via an electric insulation body. A wide-width conductor has first and second surfaces. A part of the first surface (lower surface) of the wide-width conductor is electrically connected to the main-current output side of the IGBT. The wide-width conductor forms a current path of the IGBT and a heat radiation path of a thermal loss of the IGBT. A temperature sensor is arranged on the second surface (upper surface) that corresponds to the part of the first surface of the wide-width conductor.

### DESCRIPTION OF THE INVENTION

It is an objective of the invention to improve and facilitate the determination and measurement of physical conditions of power semiconductor chips packaged into a module.

This objective is achieved by the subject-matter of the independent device claim 1. Further exemplary embodiments are evident from the dependent claims and the following description.

The invention relates to a power semiconductor module, comprising: a substrate with a metallization layer, which is structured;at least one semiconductor chip bonded to the metallization layer with a first side;a metal clip, which is a strip of metal, bonded with a first planar part to a second side of the semiconductor chip opposite to the first side and bonded with a second planar part to the metallization layer;a mold encapsulation at least partially enclosing the substrate and partially enclosing the metal clip, the mold encapsulation having a recess approaching towards the first planar part of the metal clip;wherein the semiconductor chip, to which the metal clip is bonded, is completely enclosed by the mold encapsulation, the substrate and the metal clip;wherein the first planar part of the metal clip is at least partially exposed by the recess;wherein a circuit board is attached to the mold encapsulation above the recess; and the circuit board carries a sensor accommodated in the recess. The semiconductor module may be a device mechanically and electrically interconnecting one or more semiconductor chips with each other and with terminals that may be exposed by a housing of the module. Here and in the following, the term power may relate to the ability of the semiconductor module and/or components of the semiconductor module to process currents of more than 10 A and/or voltages of more than 100 V.

The substrate may be insulating and/or made of polymers and/or ceramics that may be covered on one or both sides with a metallization layer. The substrate may also be not insulating, for example may be based on a leadframe. The metallization layer may be structured, i.e. divided into several areas, which may be used for connecting and/or bonding one or more semiconductor chips, electrical contacts and/or terminals.

The substrate also may be based on a leadframe. For example, the metallization layer may be made of a leadframe. The metallization layer and/or the leadframe may also provide metal parts, which provide a terminal of the power semiconductor module. The second part of the metal clip may be bonded to a part of the metallization layer providing a terminal of the power semiconductor module.

The module comprises one or more semiconductor chips, which may be controllable devices, such as transistors and/or thyristors. It also may be that some of the semiconductor chips are diodes. The semiconductor chips may be based on Si or SiC or another wide bandgap material.

The one or more semiconductor devices may be bonded with the first or bottom side to the metallization layer. Here and in the following, bonding may refer to soldering, sintering, gluing, welding and/or any other solid metallurgical interconnection.

On the second and/or top side of the one or more chips, a metal clip is bonded with a first part and/or first end.

With a second part and/or second end, the metal clip is bonded to the metallization layer, in particular besides the semiconductor chip. The metal clip is a strip of metal, which may be thinner in a direction orthogonal to the extension direction of the metallization layer as compared to an orthogonal direction. The metal clip may be provided by a leadframe. The first part and/or the second part of the metal clip are planar. A middle part of the clip may be bent.

The substrate with the metallization layer, and the one or more metal clips are at least partially encapsulated into a mold encapsulation, which may be formed by molding of a plastics material.

Above one or more semiconductor chips, one or more recesses are provided in the mold encapsulation, which approaches towards the respective metal clip above the chip to which it is bonded.

The recess may be an opening and/or hole in the mold encapsulation, which runs through the material of the mold encapsulation towards the metal clip.

Except the one or more recesses, the mold encapsulation completely encloses the one or more semiconductor chips and the one or more metal clips together with the substrate. In particular, a middle part of the metal clip and the second part of the metal clip bonded to the metallization layer may be completely encapsulated into the material of the mold encapsulation.

The semiconductor chip is bonded with its bottom side to the metallization layer. All other parts of the semiconductor chip not bonded to the metallization layer and the metal clip are encapsulated by the mold encapsulation.

The recesses allow to nearly directly access the power semiconductor chips, while the metal clip and mold encapsulation protect the semiconductor chips from environment conditions. The recesses may be provided for any multichip power semiconductor module with planar topside interconnection, provided by a clip and/or leadframe.

The first part of the metal clip may provide protection against mechanical influence, such as spring contacting. The footprint of the contact zone may be kept small compared to separate exposed die and pad regions that may require own keep-out zones. Furthermore, the first part of the metal clip may be used for thermal buffering under transient overloads.

The semiconductor chip, to which the metal clip is bonded, is completely enclosed by the mold encapsulation, the substrate and the metal clip. All parts of the chip, which are not in contact with the metallization layer, the metal clip and other electrical interconnections, are in contact with the material of the mold encapsulation.

The recess, the first part of the metal clip, the semiconductor chip and the substrate are stacked one above the other. The recess is arranged above the first part of the metal clip. The first part of the metal clip is arranged on the semiconductor chip. The semiconductor chip is arranged on the substrate.

The first part of the metal clip is at least partially exposed by the recess. Here, exposed means that the surface of the metal clip, is at the bottom wall of the recess. In such a way, an electrical connection to the metal clip may be made through the recess.

The metal clip may be bonded to a load current electrode and/or power electrode of the semiconductor chip such as a source electrode or emitter electrode. The metal clip also may be bonded to a control electrode of the semiconductor chip, such as a gate electrode. With an at least partially exposed metal clip, the recess allows an access to the respective power or control potential of the semiconductor chip.

The power semiconductor module further comprises a circuit board attached to the mold encapsulation above the recess. The circuit board may be a printed circuit board and/or may be a gate driver board. The circuit board may be attached to a side of the mold encapsulation, in which the one or more recesses are provided.

The circuit board carries a sensor and optionally contact elements, such as press-pins, which is/are accommodated in the one or more recesses. One or more sensors and/or press-pins may be attached at the side of the circuit board facing the mold encapsulation, for example to sense and/or extract chip individual diagnostics.

According to an embodiment of the invention, a sealing ring surrounding the recess is provided between the circuit board and the mold encapsulation. The sealing ring may seal an interior of the recess from an environment of the power semiconductor module. The sealing ring may seal the recess against dust and contamination. The sealing ring may be made of the material of the mold encapsulation or may be an additional component, which may be made of a different material. The sealing ring may be a sealing rim.

According to an embodiment of the invention, a non-contact temperature sensor facing into the recess towards the metal clip is connected to the circuit board. A space may be provided between the non-contact temperature sensor and the metal clip and/or the cover layer on the metal clip. A non-contact temperature sensor may be an IR temperature diode or other optical sensors for remote temperature sensing.

According to an embodiment of the invention, a contact temperature sensor connected to the circuit board is arranged in the recess in thermal contact with the metal clip. Such a temperature sensor, for example, a temperature dependent resistor, may be in direct contact with the metal clip or the cover layer on the metal clip.

According to an embodiment of the invention, a magnetic field sensor connected to the circuit board is arranged in the recess. The magnetic field sensor may be a giant magneto-resistive sensor.

According to an embodiment of the invention, a press-pin connected to the circuit board is pressed onto the metal clip. Such a press-pin may provide an auxiliary power electrode connection between the circuit board and the power semiconductor electrode to which the metal clip is connected. The press-pin may be bonded to the metal clip, for example by an electrically conductive adhesive.

In general, a press-pin may be a pin-shaped metal element protruding from the circuit board, which is substantially stiff to be pressed against the metal clip.

According to an embodiment of the invention, the power semiconductor module further comprises a further, second recess running and/or approaching towards a part of the semiconductor chip not covered by the metal clip. For example, the second recess may at least partially expose a control electrode of the semiconductor chip. A further press-pin connected to the circuit board may be pressed to the semiconductor chip in the further, second recess. Such a press-pin may provide a control electrode connection between the circuit board, which may be a gate driver board, and the power semiconductor electrode to which the metal clip is connected. The press-pin may be bonded to the control electrode, for example by an electrically conductive adhesive.

According to an embodiment of the invention, the power semiconductor module further comprises a further, for example third, recess running and/or approaching towards a part of the metallization layer of the substrate. Such a recess may allow access specific areas of the metallization layer and/or selected potentials on the substrate.

A press-pin, which is connected to the circuit board, may be pressed to the metallization layer in the further recess. The press-pin may be bonded to the metallization layer, for example by an electrically conductive adhesive.

According to an embodiment of the invention, a capacitor mounted to the circuit board opposite to the recess is connected to the press-pin. The recess towards the metallization layer, or two such recesses, may be used for connecting a decoupling capacitor and/or other filter components (for example passives and non-linear devices such as diodes), which may be mounted on the circuit board, to the metallization layer. The capacitor and/or the other filter components may be arranged in close proximity to the one or more press-pins and/or to the recess. This may result in decreased oscillations and switching losses.

According to an embodiment of the invention, a cooling fluid is guided through the recess. The recess may be in fluid exchange with a cooling guide and/or cooling channel of the power semiconductor module. For example, the recess may be cooling fluid tight covered with a covering member and the cooling fluid may be guided along the recess. The one or more recesses may be used to guide a coolant fluid along a topside of the one or more semiconductor chips.

It also may be that a bottom side of the power semiconductor module is cooled, allowing for double-side cooling. A baseplate and/or cooling plate, for example with cooling channels, may be attached to the substrate opposite to the one or more semiconductor chips. This design may enable an improved chip-level power density by double-side cooling.

According to an embodiment of the invention, a nozzle for cooling fluid is directed inside the recess for jet impingement cooling. The cooling guide and/or cooling channel inside the recess may be formed as a nozzle to form a jet of cooling fluid, which is directed against the metal clip. This may even improve the cooling of the semiconductor chip below the metal clip.

In summary, such a design may enable a non-invasive, low-cost and high-sensitivity diagnostics with the option to inspect each chip of a multichip power semiconductor module. The decision for implementation of diagnostics may be moved to the design of a respective gate driver board including sensors and/or press-pin contacts. For example, optical and physical-contact sensing may be enabled without the need of adding auxiliary terminals to the power semiconductor module.

With the recesses in the module, a quality control and end-of-line testing, such as electrical screening of each semiconductor chip, is possible. A calibration of chip-individual and chip-group parameters prior to field operation is possible. Online diagnostics in operation may be performed per chip, per chip group, per phase-leg module and/or per similar module in the fleet. Also, health analysis during service intervals is possible.

Further applications may be lifetime prognostics, preventive maintenance, lifetime extension, fault tolerance and preventive actions for configuration with chip-individual gate control. For example, a reduced load may be applied to aged chip via a respective control, defect chip may be fused out, surge current may be redistributed to parallel devices, etc.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a cross-section through a power semiconductor module according to an exemplary embodiment of the invention.
Fig. 2 schematically shows a cross-section through a power semiconductor module according to a further exemplary embodiment of the invention.
Fig. 3 schematically shows a cross-section through a power semiconductor module according to an illustrative embodiment of the invention not covered by the claims but useful for understanding the invention.
Fig. 4 schematically shows a cross-section through a power semiconductor module according to a further illustrative embodiment of the invention not covered by the claims but useful for understanding the invention.
Fig. 5 schematically shows a cross-section through a power semiconductor module according to a further illustrative embodiment of the invention not covered by the claims but useful for understanding the invention.
Fig. 6 schematically shows a cross-section through a power semiconductor module according to a further illustrative embodiment of the invention not covered by the claims but useful for understanding the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

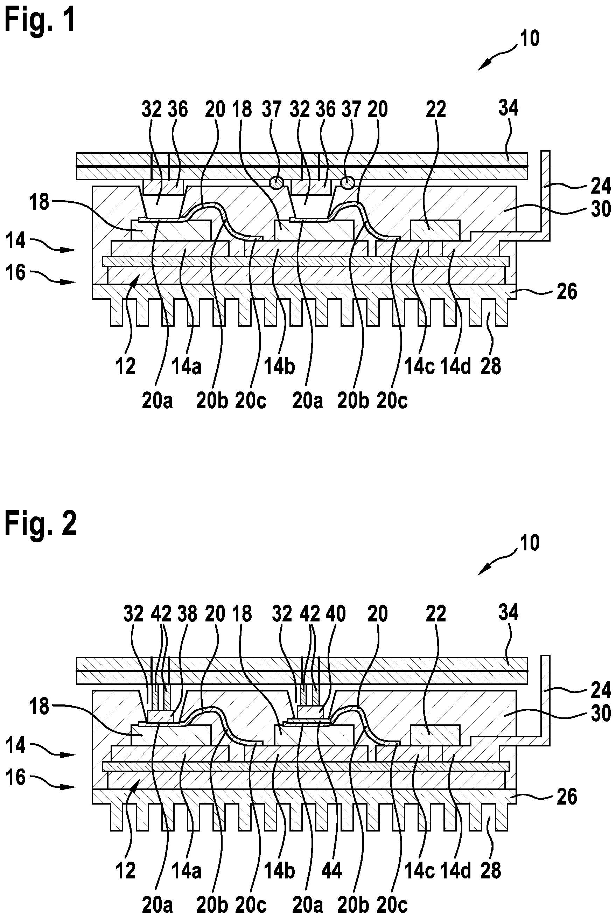

Fig. 1 shows a power semiconductor module 10. The power semiconductor module 10 comprises a substrate 12, for example a DBC (direct bonded copper) substrate, which has two metallization layers 14, 16 on each side. The metallization layer 14 is structured into areas 14a, 14b, 14c, 14d, and semiconductor chips 18 are bonded with a first power electrode to some of the areas 14a, 14b. The opposite side of each of the semiconductor chips 18 with a second power electrode is bonded to a metal clip 20, which is bonded to a further area 14b, 14c of the metallization layer 14.

The metal clip 20 comprises a first part 20a bonded to the power electrode, a middle part 20b and a second part 20c, which is bonded to the metallization layer 14. The first part 20a and the second part 20c are flat members, while the middle part may be bent. The metal clip 20 also may interconnect several semiconductor chips 18 and/or may be provided by a leadframe. Bonding of the metal clip 20 to the semiconductor chip 18 and/or the metallization layer 14 may be realized by sintering, soldering or laser-bonding.

It also may be that two areas 14c, 14d of the metallization layer 14 are connected by other electronic components, such as a resistor 22. Also terminals 24 may be connected to one or more of the areas 14d.

A baseplate 26, for example with cooling channels 28, may be attached to the substrate 12 and in particular the metallization layer 16.

All the components 12, 18, 20, 22, 24 mentioned so far are enclosed by a mold encapsulation 30, which encapsulates these components, such that only the baseplate 26, a part of the terminal(s) 24 and parts of the first parts 20a of the metal clips 20 are not encapsulated in the mold material. The mold encapsulation 30 may be made by transfer molding.

The mold encapsulation 30 has a recess 32 for each semiconductor chip 18 and/or metal clip 20, which recess protrudes from a side surface of the mold encapsulation 30 towards the respective semiconductor chip 18 and/or metal clip 20. The bottom of the recess 32 is designed that such that the first part 20a of the metal clip 20 is at least partially exposed to an outside of the mold encapsulation 30. The other parts 20b, 20c of the metal clip 20 may be enclosed by the mold material. Also the semiconductor chip 18 is completely enclosed by the mold material and the metal clip 20.

With the one or more recesses 32, a semiconductor chip side is accessible and an opening and/or channel to a power electrode, such as a source or emitter electrode of the semiconductor chip, is provided.

The power semiconductor module furthermore comprises a circuit board 34, which is attached to the mold encapsulation 30 above the one or more recesses 32. The circuit board 34 may be a printed circuit board and/or may be a gate driver board. The baseplate 26 the substrate 12 and the circuit board 34 may be aligned substantially parallel to each other.

Components connected to the circuit board may be lowered into the recesses and/or may be used for sensing physical properties, such as temperature, current and voltage potential, of the metal clip 20 and/or the semiconductor chip 18 below.

One or more recesses 32 is/are used for optical temperature sensing, for example, by placing a non-contact temperature sensor 36, such as an IR diode or another sensor type into the recesses 32. The non-contact temperature sensor 36 may be bonded to the circuit board 34, where also the sensor wiring and signal analysis for the sensor 36 may be provided.

Fig. 1 also shows that one or more recesses 32 may be sealed with a sealing ring 37, which may be located between the mold encapsulation 30 and the circuit board 34. The sealing ring 37 may be an O-ring or mold material sealing lip. The sealing ring 37 may be used to keep the recess 32 free of dust and contamination.

The following Fig. 2 to 6 show embodiments of the semiconductor module 10 of Fig. 1, which show further possible usages of the recesses 32 and further embodiments of additional recesses.

Fig. 2 shows that a contact temperature sensor 38 and/or a magnetic field sensor 40 is/are arranged in the recess 32. A contact sensor 38, 40 may be connected to pins 42 of the circuit board 34, which press the sensor 38, 40 against the bottom of the recess 32 and/or the metal clip 20.

The magnetic field sensor 40 may be giant magneto-resistive sensors. For the case that the sensor requires galvanic insulation, a dielectric layer 44 may be provided between sensor 40 and the metal clip 20. Various materials may be used, such as cold gas sprayed (CGS) Al₂O₃, which may be pre-applied to the metal clip 20. This material may be applied at low cost and/or also may provide high thermal conductivity.

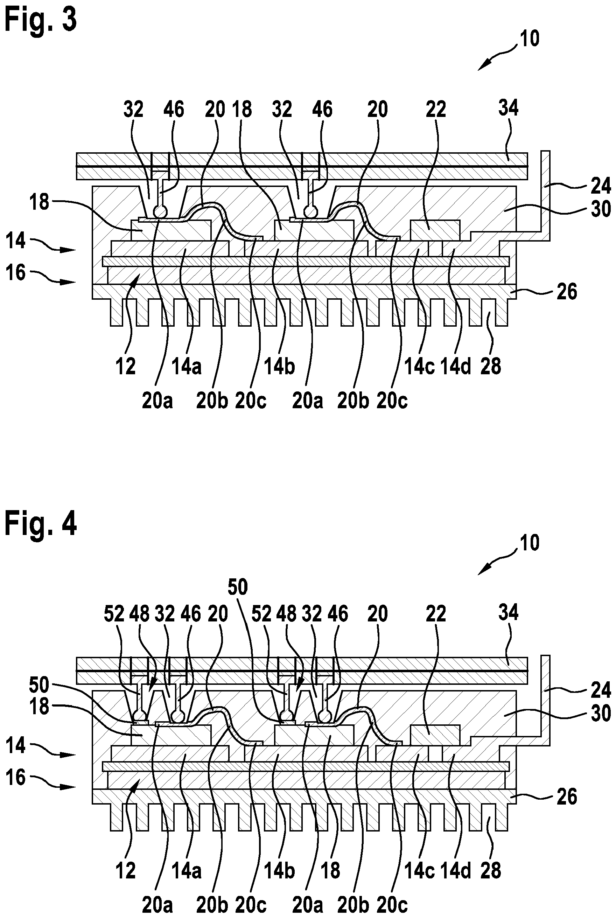

Fig. 3 shows that press-pins 46 protruding from the circuit board 34 may be used to electrically contact the metal clip 20. In such a way, an electrical connection between the circuit board 34 and a power electrode (such as the source or emitter electrode) of the semiconductor chip 18 may be generated.

The press-pins 46 may be integrated into the circuit board and may be pressed with a spring force against the metal clips 20. A layer of Au plating may be provided on the clip 20 to guarantee a low-ohmic and stable contact resistance. The topside press-pin contacts on the source or emitter electrode of the chip 18 may be used to extract chip-individual voltage transients that may be otherwise hidden in the average voltage signal at the terminals.

Such connections also may be used for chip temperature-sensitive electrical parameter (TSEP) sensing.

To increase the contact reliability of the press-pins 46 it is a further option to bond the press-pins 46 to the metal clips 20 by adding a bond material, for example, by capping tips of the press-pins 46 by an electrically conductive adhesive.

Fig 4 shows that the mold encapsulation 30 has a second recess 48 for one or all of the chips 18, which runs towards a part of the semiconductor chip 18 not covered by the metal clip 20. The recess 48 may expose a control electrode (such as a gate electrode) of the semiconductor chip 18. A metal plate or strip 50 may be bonded to the control electrode, which also together with the mold encapsulation may complete enclose the parts of the semiconductor chip 18 surrounding the control electrode.

A second press-pin 52 of the circuit board 34 may be pressed through the recess 48 against the control electrode and/or the metal strip 50. In such a way, an electric connection between the circuit board 34 and the respective control electrode may be generated. The press-pin 52 may be attached to the circuit board 34 and/or bonded to the chip 18 like the press-pins 46.

With electrical connections to the source/emitter and the gate full TSEP sensing including the gate signals and/or chip-individual control for lifetime extension may be possible.

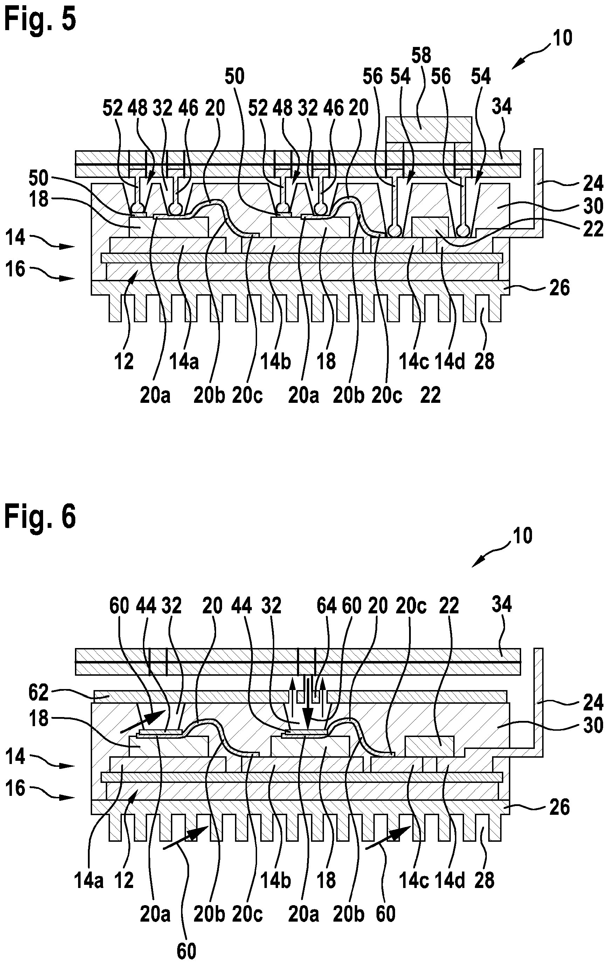

Fig. 5 shows further recesses 54 in the mold encapsulation 30, each of which runs towards an area 14c, 14d of the metallization layer 14. A press-pin 56 of the circuit board 34 may be pressed through each recess 54 against the area 14c, 14d exposed by the recess 54. The press-pins 56 may be attached to the circuit board 34 and/or bonded to the metallization layer 14 like the press-pins 46.

The press-pins 56 may be used to read-out an on-board sensor, such as a current shunt, a humidity sensor, etc., which may be enclosed in the mold encapsulation 30. The corresponding signals may be processed by the circuit board 34. The press-pins 56 also may be used to contact filter components, such as a decoupling capacitor 58. The filter components may be provided in close proximity to the recess on the circuit board 34. A decoupling capacitor 58 between DC+ and DC- potential areas 14c, 14d of the substrate 12 may be very useful in limiting oscillations and decreasing switching losses.

Fig. 6 shows that recesses 32 also may be used for cooling a topside of the semiconductor chips 18. A bottom side cooling of the semiconductor chips 18 may be performed by the baseplate 26 and/or via the substrate 12. In such a way, double-side cooling is possible.

A cooling fluid 60, such as water, water glycol mixtures or an insulating two-phase cooling fluid, may be guided through the recess 32. The same cooling fluid may be guided through cooling channels 28 of the baseplate 26. The cooling fluid 60 may be actively pumped through the recess 32 and/or the channels 28.

A recess 32 used for cooling may by partially covered by a cover plate 62 for generating a cooling channel. The cover plate 62 may be attached to an outer surface of the mold encapsulation 30. The cover plate 62 may be an Al sheet adhesively bonded to the mold encapsulation 30.

When non-dielectric cooling fluids 60, such as water and/or water glycol mixtures are used, the part 20a of the metal clip 20 exposed by the recess may be covered by a cover layer 44, which insulates the metal clip 20 and the chip 18 from the cooling fluid 60.

The cooling may be based on a parallel cooling fluid flow, for example along the metal clip 20.

The cooling may be based on a perpendicular flow, for example by focusing a high-speed fluid jet on the metal clip 20. A nozzle and/or flow-guide 64, which may be provided by the cover plate 62, may guide the cooling fluid 60 in a jet and/or beam against the metal clip 20.

### LIST OF REFERENCE SYMBOLS

- 10: power semiconductor module
- 12: substrate
- 14: metallization layer
- 14a, 14b, 14c: structured area
- 16: metallization layer
- 18: semiconductor chips
- 20: metal clip
- 20a: first part
- 20b: middle part
- 20c: second part
- 22: resistor
- 24: terminal
- 26: baseplate
- 28: cooling channel
- 30: mold encapsulation
- 32: recess
- 34: circuit board
- 36: non-contact temperature sensor
- 37: sealing ring
- 38: contact temperature sensor
- 40: magnetic field sensor
- 42: pin
- 44: cover layer
- 46: press-pin
- 48: second recess
- 50: metal plate/strip
- 52: second press-pin
- 54: further recess
- 56: further press-pin
- 58: decoupling capacitor
- 60: cooling fluid
- 62: cover plate
- 64: nozzle

## Claims

1. A power semiconductor module (10), comprising:
a substrate (12) with a metallization layer (14), which is structured;
at least one semiconductor chip (18) bonded to the metallization layer (14) with a first side;
a metal clip (20), which is a strip of metal, bonded with a first planar part (20a) to a second side of the semiconductor chip (18) opposite to the first side and bonded with a second planar part (20b) to the metallization layer (14);
a mold encapsulation (30) at least partially enclosing the substrate (12) and partially enclosing the metal clip (20), the mold encapsulation (30) having a recess (32) approaching towards the first planar part (20a) of the metal clip (20);
wherein the semiconductor chip (18), to which the metal clip (20) is bonded, is completely enclosed by the mold encapsulation (30), the substrate (12) and the metal clip (20);
wherein the first planar part (20a) of the metal clip (20) is at least partially exposed by the recess (32);
**characterised in that** a circuit board (34) is attached to the mold encapsulation (30) above the recess;
the circuit board (34) carries a sensor (36, 38, 40) accommodated in the recess (32).

2. The power semiconductor module (10) of claim 1,
wherein a sealing ring (37) surrounding the recess (32) is provided between the circuit board (34) and the mold encapsulation (30).

3. The power semiconductor module (10) of claim 1 or 2,
wherein the sensor is a non-contact temperature sensor (36) facing into the recess (32) towards the metal clip (20) and connected to the circuit board (34).

4. The power semiconductor module (10) of one of claims 1 and 2,
wherein the sensor is a contact temperature sensor (38) connected to the circuit board (34) and arranged in the recess (32) in thermal contact with the metal clip (20).

5. The power semiconductor module (10) of one of claims 1 and 2,
wherein the sensor is a magnetic field sensor (40) connected to the circuit board (34) and arranged in the recess (32).

6. The power semiconductor module (10) of one of the previous claims,
wherein a press-pin (46) connected to the circuit board (34) and accommodated in the recess (32) is pressed onto the metal clip (20).

7. The power semiconductor module (10) of one of the previous claims, further comprising:
a further recess (54) towards a part (14c, 14d) of the metallization layer (14) of the substrate (12);
wherein a press-pin (56) connected to the circuit board (34) is pressed to the metallization layer (14) in the further recess (54).

8. The power semiconductor module (10) of claim 7,
wherein a capacitor (58) mounted to the circuit board (34) opposite to the recess (32) is electrically connected to the press-pin (56).

9. The power semiconductor module (10) of one of the previous claims,
wherein a cooling fluid (60) is guided through the recess (32).

10. The power semiconductor module (10) of claim 9,
wherein a nozzle (64) for cooling fluid (60) is directed inside the recess (32) for jet impingement cooling.

## Patentansprüche

1. Leistungshalbleitermodul (10), umfassend:
ein Substrat (12) mit einer Metallisierungsschicht (14), die strukturiert ist;
mindestens einen Halbleiterchip (18), der mit einer ersten Seite an die Metallisierungsschicht (14) gebondet ist;
eine Metallklammer (20), die ein Metallstreifen ist, der mit einem ersten ebenen Teil (20a) an eine zweite Seite des Halbleiterchips (18) gegenüber der ersten Seite gebondet und mit einem zweiten ebenen Teil (20b) an die Metallisierungsschicht (14) gebondet ist;
eine Formverkapselung (30), die das Substrat (12) zumindest teilweise einschließt und die Metallklammer (20) teilweise einschließt, wobei die Formverkapselung (30) eine Aussparung (32) aufweist, die sich dem ersten ebenen Teil (20a) der Metallklammer (20) annähert;
wobei der Halbleiterchip (18), an den die Metallklammer (20) gebondet ist, vollständig von der Formverkapselung (30), dem Substrat (12) und der Metallklammer (20) eingeschlossen ist;
wobei der erste ebene Teil (20a) der Metallklammer (20) zumindest teilweise durch die Aussparung (32) freigelegt ist;
**dadurch gekennzeichnet, dass** eine Schaltungsplatine (34) an der Formverkapselung (30) über der Aussparung befestigt ist; wobei die Schaltungsplatine (34) einen Sensor (36, 38, 40) trägt, der in der Aussparung (32) aufgenommen ist.

2. Leistungshalbleitermodul (10) nach Anspruch 1,
wobei ein Dichtring (37), der die Aussparung (32) umgibt, zwischen der Schaltungsplatine (34) und der Formverkapselung (30) bereitgestellt ist.

3. Leistungshalbleitermodul (10) nach Anspruch 1 oder 2,
wobei der Sensor ein kontaktloser Temperatursensor (36) ist, der in die Aussparung (32) zu der Metallklammer (20) zeigt und mit der Schaltungsplatine (34) verbunden ist.

4. Leistungshalbleitermodul (10) nach einem der Ansprüche 1 und 2,
wobei der Sensor ein Temperaturkontaktsensor (38) ist, der mit der Schaltungsplatine (34) verbunden und in der Aussparung (32) in thermischem Kontakt mit der Metallklammer (20) angeordnet ist.

5. Leistungshalbleitermodul (10) nach einem der Ansprüche 1 und 2,
wobei der Sensor ein Magnetfeldsensor (40) ist, der mit der Schaltungsplatine (34) verbunden und in der Aussparung (32) angeordnet ist.

6. Leistungshalbleitermodul (10) nach einem der vorhergehenden Ansprüche,
wobei ein Einpressstift (46), der mit der Schaltungsplatine (34) verbunden und in der Aussparung (32) aufgenommen ist, auf die Metallklammer (20) gepresst ist.

7. Leistungshalbleitermodul (10) nach einem der vorhergehenden Ansprüche, ferner umfassend:
eine weitere Aussparung (54) hin zu einem Teil (14c, 14d) der Metallisierungsschicht (14) des Substrats (12);
wobei ein Einpressstift (56), der mit der Schaltungsplatine (34) verbunden ist, in der weiteren Aussparung (54) an die Metallisierungsschicht (14) gepresst ist.

8. Leistungshalbleitermodul (10) nach Anspruch 7,
wobei ein Kondensator (58), der an der Schaltungsplatine (34) gegenüber der Aussparung (32) montiert ist, elektrisch mit dem Einpressstift (56) verbunden ist.

9. Leistungshalbleitermodul (10) nach einem der vorhergehenden Ansprüche,
wobei ein Kühlfluid (60) durch die Aussparung (32) geführt ist.

10. Leistungshalbleitermodul (10) nach Anspruch 9,
wobei eine Düse (64) für Kühlfluid (60) in die Aussparung (32) zur Strahlaufprallkühlung gerichtet ist.

## Revendications

1. Module d'alimentation à semi-conducteur (10), comprenant :
un substrat (12) avec une couche de métallisation (14), laquelle est structurée ;
au moins une puce semi-conductrice (18) liée à la couche de métallisation (14) avec un premier côté ;
un clip métallique (20), lequel est une bande de métal, liée avec une première partie plane (20a) à un deuxième côté de la puce semi-conductrice (18) opposé au premier côté et liée avec une deuxième partie plane (20b) à la couche de métallisation (14) ;
une encapsulation de moule (30) enfermant au moins partiellement le substrat (12) et enfermant partiellement le clip métallique (20), l'encapsulation de moule (30) ayant un évidement (32) s'approchant vers la première partie plane (20a) du clip métallique (20) ;
la puce semi-conductrice (18), à laquelle le clip métallique (20) est lié, étant complètement enfermée par l'encapsulation de moule (30), le substrat (12) et le clip métallique (20) ;
la première partie plane (20a) du clip métallique (20) étant au moins partiellement exposée par l'évidement (32) ;
**caractérisé en ce qu'**une carte de circuit imprimé (34) est attachée à l'encapsulation de moule (30) au-dessus de l'évidement ; la carte de circuit imprimé (34) porte un capteur (36, 38, 40) logé dans l'évidement (32).

2. Module d'alimentation à semi-conducteur (10) selon la revendication 1,
dans lequel une bague d'étanchéité (37) entourant l'évidement (32) est prévue entre la carte de circuit imprimé (34) et l'encapsulation de moule (30).

3. Module d'alimentation à semi-conducteur (10) selon la revendication 1 ou la revendication 2,
dans lequel le capteur est un capteur de température sans contact (36) faisant face à l'évidement (32) vers le clip métallique (20) et connecté à la carte de circuit imprimé (34) .

4. Module d'alimentation à semi-conducteur (10) selon l'une des revendications 1 et 2,
dans lequel le capteur est un capteur de température de contact (38) connecté à la carte de circuit imprimé (34) et agencé dans l'évidement (32) en contact thermique avec le clip métallique (20).

5. Module d'alimentation à semi-conducteur (10) selon l'une des revendications 1 et 2,
dans lequel le capteur est un capteur de champ magnétique (40) connecté à la carte de circuit imprimé (34) et agencé dans l'évidement (32).

6. Module d'alimentation à semi-conducteur (10) selon l'une des revendications précédentes,
dans lequel une cheville de presse (46) connectée à la carte de circuit imprimé (34) et logée dans l'évidement (32) est pressée sur le clip métallique (20).

7. Module d'alimentation à semi-conducteur (10) selon l'une des revendications précédentes, comprenant en outre :
un autre évidement (54) vers une partie (14c, 14d) de la couche de métallisation (14) du substrat (12) ;
dans lequel une cheville de presse (56) connectée à la carte de circuit imprimé (34) est pressée contre la couche de métallisation (14) dans l'autre évidement (54).

8. Module d'alimentation à semi-conducteur (10) selon la revendication 7,
dans lequel un condensateur (58) monté sur la carte de circuit imprimé (34) opposée à l'évidement (32) est électriquement connecté à la cheville de presse (56).

9. Module d'alimentation à semi-conducteur (10) selon l'une quelconque des revendications précédentes,
dans lequel un fluide de refroidissement (60) est guidé à travers l'évidement (32).

10. Module d'alimentation à semi-conducteur (10) selon la revendication 9,
dans lequel une buse (64) pour fluide de refroidissement (60) est dirigée à l'intérieur de l'évidement (32) pour un refroidissement par collision du jet.
